# FASCICULE DE BREVET EUROPEEN

(11) **EP 2 917 788 B1**
(45) Date de publication et mention de la délivrance du brevet: **26.04.2017**
(21) Numéro de dépôt: 13789254.3
(22) Date de dépôt: 06.11.2013
(51) Int. Cl.: G04B 17/26, G04B 15/12, G04B 15/14, C30B 1/10, C30B 29/18

(54) **PROCÉDÉ DE RÉALISATION D'UN ÉLÉMENT FLEXIBLE MULTISTABLE**
VERFAHREN ZUR HERSTELLUNG EINES MULTISTABILEN FLEXIBLEN ELEMENTS
METHOD FOR THE PRODUCTION OF A MULTISTABLE FLEXIBLE ELEMENT

(30) Priorité: 09.11.2012 EP 12192026
(43) Date de publication de la demande: 16.09.2015
(73) Titulaire: Nivarox-FAR S.A., 2400 Le Locle (CH)
(72) Inventeur: STRANCZL, Marc, CH-1260 Nyon (CH); HESSLER, Thierry, CH-2024 St-Aubin (CH)
(74) Mandataire: Giraud, Eric
(86) Numéro de dépôt international: PCT/EP2013/073116
(87) Numéro de publication internationale: WO 2014/072317

(56) Documents cités:
- EP-A1- 1 562 207
- EP-A1- 2 407 831
- WO-A1-2007/000271

## Description

### Domaine de l'invention

L'invention concerne des procédés de réalisation d'un composant flexible multistable, notamment d'une lame flexible bistable.

L'invention concerne le domaine des mécanismes d'horlogerie, notamment des mécanismes d'échappement.

### Arrière-plan de l'invention

L'amélioration de la marche et la recherche d'un meilleur rendement sont des préoccupations constantes des constructeurs de montres mécaniques, qui cherchent à obtenir la plus grande réserve de marche possible, conjuguée avec régularité, précision, et sécurité dans les conditions d'utilisation les plus dures.. L'ensemble réglant, et le mécanisme d'échappement sont au coeur de cette problématique.

En particulier, dans les montres mécaniques, les échappements doivent répondre à plusieurs critères dits de sécurité. Une des sécurités, le mécanisme anti-galop, vise à empêcher l'extension angulaire du balancier au-delà d'un angle normal de rotation.

Le brevet EP 1 801 668 B1 au nom de MONTRES BREGUET SA propose un mécanisme dont la structure est caractéristique en ce qu'il comprend un pignon monté sur l'arbre du balancier. Ce pignon engrène une roue dentée dont au moins un rayon vient buter contre un arrêt fixe si le balancier est entrainé au-delà de son angle normal de rotation. Ce mécanisme influence l'inertie du balancier et perturbe ainsi ses oscillations. De plus, l'engrenage qui le compose présente des frottements qui perturbent également le mécanisme de régulation.

Le document EP 1 666 990 A2 au nom de MONTRES BREGUET SA expose un autre mécanisme anti-galop basé sur l'expansion du spiral: un bras de blocage, fixé sur la spire extérieure du spiral, s'interpose entre un doigt solidaire du balancier et deux colonnes solidaires du pont du balancier. Ce blocage a lieu uniquement en cas d'expansion excessive du spiral au-delà d'un angle dépassant son angle de fonctionnement normal. Ce mécanisme limite l'angle de rotation uniquement dans un sens de rotation.

Le document EP 2 450 756 A1 NIVAROX décrit un dispositif anti-galop pour mécanisme d'échappement, avec un mobile pivotant porteur d'un doigt lequel circule dans une piste de came solidaire du balancier. Ce mobile pivotant peut comporter un bras avec une bascule bistable, notamment une lame élastique bistable.

Le document EP 2 037 335 A2 ENZLER-VON GUNTEN décrit une ancre qui comporte deux bras munis de palettes, et une fourchette d'ancre, l'ensemble étant réalisé de façon monobloc avec deux lames flexibles de fixation, qui définissent un axe virtuel de pivotement de l'ancre, et qui autorisent le pivotement de l'ancre lors de leur flexion, les axes médians de ces deux lames se coupant au niveau de cet axe virtuel.

Le document WO 2007/000 271 au nom de ETA décrit une pièce de micro-mécanique renforcée avec une âme en silicium recouverte d'un matériau amorphe épais, notamment du dioxyde de silicium en couche d'épaisseur supérieure à 50 nm.

Le document EP 2 407 831 A1 au nom de ROLEX décrit un spiral en silicium ou quartz avec des ajours alternant avec des ponts, sur toute la longueur d'au moins une spire. Notamment un noyau en silicium est enveloppé par une couche de dioxyde de silicium amorphe.

Le document EP 1 562 207 A1 au nom de ST MICROELECTRONICS SA décrit un procédé de réalisation d'un élément flexible multistable, en l'occurrence une membrane, comportant des étapes de dépôt de couches de nitrure de silicium qui comportent des contraintes de compression interne donnant, après refroidissement, la bistabilité de la membrane.

En somme, les mécanismes de sécurité connus présentent, chacun, au moins un des inconvénients récurrents : la perturbation des oscillations par modification de l'inertie de l'organe régulateur, la dégradation du rendement sous l'effet de frottement, la limitation de l'angle de rotation dans un sens de rotation seulement.

### Résumé de l'invention

La présente invention vise à améliorer le rendement d'une montre, et à résoudre les problèmes cités plus haut, en permettant la fabrication de composants ne perturbant que très faiblement les oscillations du balancier, avec une perte de rendement négligeable ou nulle, et en limitant la course angulaire du balancier dans les deux sens de rotation.

L'invention concerne un procédé de réalisation d'un élément flexible multistable, par lequel :
- on grave un composant en silicium avec une poutre reliant deux extrémités d'une masse rigide de section supérieure à dix fois celle de ladite poutre,
- on fait croître du SiO₂, à 1100°C, pendant une durée ajustée pour obtenir, au niveau de ladite poutre, un premier rapport supérieur à 1 entre la section d'une première couche périphérique de SiO₂, et celle d'une première âme de silicium, et, au niveau de ladite masse, un deuxième rapport entre la section d'une deuxième couche périphérique de SiO₂, et celle d'une deuxième âme de silicium, inférieur au centième dudit premier rapport;
- on refroidit à l'ambiante, pour déformer en flambage ladite poutre lors du refroidissement de ladite masse se contractant davantage que ladite poutre.

Notamment un premier procédé de réalisation d'une lame flexible multistable est réalisé par la succession des opérations suivantes :
- on grave un composant en silicium dans lequel une poutre longiligne de faible section fait la liaison entre deux extrémités d'au moins une masse, de forte section au moins supérieure à dix fois ladite faible section, ladite au moins une masse constituant un cadre rigide ;
- on soumet ledit composant, dans un four, à un procédé de croissance de dioxyde de silicium SiO₂ par maintien pendant plusieurs heures à une température de 1100°C ;
- on ajuste cette durée de plusieurs heures de façon à obtenir, au niveau de ladite poutre, une première âme en silicium enveloppée par une première couche périphérique, et au niveau de ladite masse, une deuxième âme en silicium enveloppée par une deuxième couche périphérique, et de façon à ce qu'un premier rapport entre, d'une part la section de ladite première couche périphérique de ladite poutre formée de dioxyde de silicium SiO₂ ,et d'autre part la section de ladite première âme de ladite poutre formée de silicium soit supérieur à 1,
- et de façon à ce qu'un deuxième rapport entre, d'une part la section de ladite deuxième couche périphérique de ladite masse formée de dioxyde de silicium SiO₂, et d'autre part la section de ladite deuxième âme de ladite masse formée de silicium, soit inférieur au centième dudit premier rapport;
- on effectue un refroidissement à la température ambiante, environ 20°C, de façon à déformer en flambage ladite poutre lors du refroidissement de ladite au moins une masse, dont la contraction lors de ce refroidissement est supérieure à la contraction de ladite poutre.

L'invention concerne encore un autre procédé de réalisation d'une lame flexible multistable par la succession des opérations suivantes :
- on grave un composant en silicium dans lequel une poutre longiligne de faible section fait la liaison entre au moins deux masses, chacune de forte section au moins supérieure à dix fois ladite faible section, lesdites deux masses constituant ensemble ou avec d'autres éléments de structure un cadre rigide;
- on soumet ledit composant, dans un four, à un procédé de croissance de dioxyde de silicium SiO₂ par maintien pendant plusieurs heures à une température de 1100°C ;
- on ajuste cette durée de plusieurs heures de façon à obtenir, au niveau de ladite poutre, une première âme en silicium enveloppée par une première couche périphérique, et au niveau de chaque dite masse, une deuxième âme en silicium enveloppée par une deuxième couche périphérique, et de façon à ce qu'un premier rapport entre, d'une part la section de ladite première couche périphérique de ladite poutre formée de dioxyde de silicium SiO₂ ,et d'autre part la section de ladite première âme de ladite poutre formée de silicium soit supérieur à 1,
- et à ce qu'un deuxième rapport entre, d'une part la section de chacune desdites deuxièmes couches périphériques desdites masses formées de dioxyde de silicium SiO₂, et d'autre part la section de chacune desdites deuxièmes âmes desdites masses formées de silicium soit inférieur au centième dudit premier rapport,
- on effectue un refroidissement à la température ambiante, environ 20°C, de façon à déformer en flambage ladite poutre lors du refroidissement desdites deux masses dont la contraction lors dudit refroidissement est supérieure à la contraction de ladite poutre.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée et en vue de face, un mécanisme horloger de limitation ou transmission, réalisé sous la forme d'un mécanisme anti-galop comportant des lames fines réalisables par un procédé selon l'invention, fixé à une structure d'un mouvement et coopérant alternativement avec l'un de plusieurs bras qu'il comporte, deux dans cette illustration, avec une cheville d'un balancier ;
- la figure 2 représente, de façon similaire à la figure 1, le même mécanisme complété par un mécanisme antichocs ;
- la figure 3 représente, de façon schématisée, trois états d'une poutre encastrée : au repos en 3A, dans un premier mode de flambage en 3B, dans un deuxième mode de flambage en 3C ;
- la figure 4 représente, de façon schématisée et en vue de face, une poutre encastrée précontrainte en flambage dans le deuxième mode de la figure 3A sous l'action d'un pivot flexible ;
- la figure 5 représente, de façon schématisée et en vue de face, une réalisation comportant des lames fines réalisables par un procédé selon l'invention selon le principe de la figure 4, avec une précontrainte par vis excentrées de la poutre en flambage, et dans une exécution monobloc ;
- la figure 6 illustre une variante de la figure 5 et où la précontrainte est réalisée par des poches d'oxyde de silicium dans un bâti en silicium ; les figures 6A et 6B illustrent, avant et après oxydation du silicium, un détail d'une zone comportant de fortes différences de section, et fortement modifiée après formation de dioxyde de silicium, et soumettant à un effort en flambage une poutre droite de section moindre ;
- la figure 7 illustre un autre principe de précontrainte par différentiel de résistance au flambage entre un réseau de poutres parallèles en silicium oxydé et une poutre seule ainsi précontrainte en flambage ; les figures 7A, 7B, 7C, illustrent des étapes successives d'un procédé d'oxydation et de mise en flambage d'une poutre ;
- la figure 8 illustre une variante avec des bras de butée anti-galop comportant des zones flexibles d'amortissement de chocs ;
- la figure 9 représente, de façon schématisée et partielle, une pièce d'horlogerie sous la forme d'une montre comportant un mouvement avec un dispositif anti-galop comportant des lames fines réalisables par un procédé selon l'invention ;
- la figure 10 illustre une configuration dans laquelle un pivot virtuel bistable du mécanisme anti-galop, comportant des lames fines réalisables par un procédé selon l'invention, est mobile en translation ;
- la figure 11 illustre un détail d'un mécanisme anti-galop comportant au moins deux niveaux pour assurer le maintien des bras du système anti-galop dans le plan de la cheville de balancier : un premier niveau supérieur avec des bras coopérant avec cette cheville, et un deuxième niveau inférieur avec un dard coopérant avec une encoche de balancier ;
- la figure 12 est une structure déformable par oxydation du silicium, en variante de celle de la figure 7A ;
- la figure 13 représente la section d'une structure en quartz monocristallin, pour la réalisation d'un mécanisme anti-galop selon un autre procédé, voisin de celui de l'invention ;
- la figure 14 illustre un mécanisme, avec une fonction de répulsion, entre la cheville de balancier et les bras du mécanisme anti-galop comportant des lames fines réalisables par un procédé selon l'invention, est remplie par des aimants situés dans une orientation verticale, et avec une coupe selon la ligne en trait interrompu ;
- la figure 15 illustre une réalisation analogue, avec une orientation dans le plan du champ magnétique ;
- la figure 16 schématise, de façon analogue à la figure 10, un cas plus général où le mouvement est quelconque, et bistable ;
- les figures 17A et 17B illustrent l'obtention de la précontrainte par rencontre des croissances d'oxyde (avant et après) dans un serpentin.
- les figures 18A et 18B (et leurs détails en figures 19A et 19B) montrent l'obtention de la précontrainte par l'ouverture des angles au sommet d'un profilé en zig-zag lors de la croissance de l'oxyde de silicium (avant et après) ;
- les figures 20A et 20B illustrent une variation d'angle obtenue par la variation (avant et après) du rayon de courbure des parois oxydées dans une zone à très faible rayon de courbure ;
- la figure 21 montre schématiquement une lame flexible bistable coopérant avec les deux extrémités d'une masse unique ;

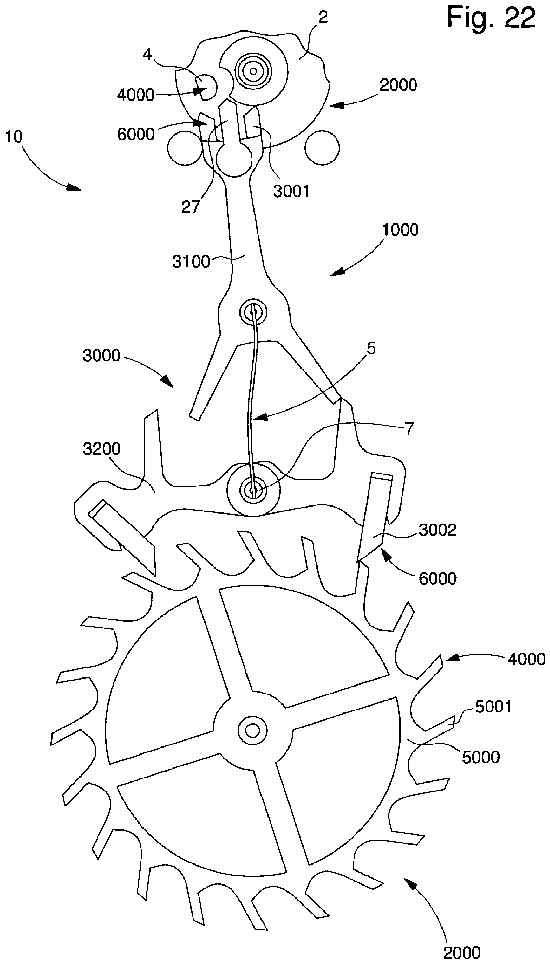

- la figure 22 illustre en vue en plan une autre application où le mécanisme horloger de limitation ou transmission est un mécanisme d'ancre entre un balancier et une roue d'échappement, l'ancre comportant une lame bistable réalisable par un procédé selon l'invention ;
- les figures 23 et 24 illustrent, de façon analogue à la figure 7 en trois images successives, avant traitement, pendant la chauffe de formation de dioxyde de silicium, et après refroidissement à l'ambiante, 23A, 23B, 23C et 24A, 24B, 24C, des procédés de fabrication d'un élément flexible multistable avec une poutre de faible section entre deux extrémités, respectivement d'une même masse de forte section, et de deux masses distinctes également de forte section.

### Description détaillée des modes de réalisation préférés

L'invention concerne un procédé par lequel on réalise une lame flexible multistable, notamment bistable, pour un mécanisme d'horlogerie.

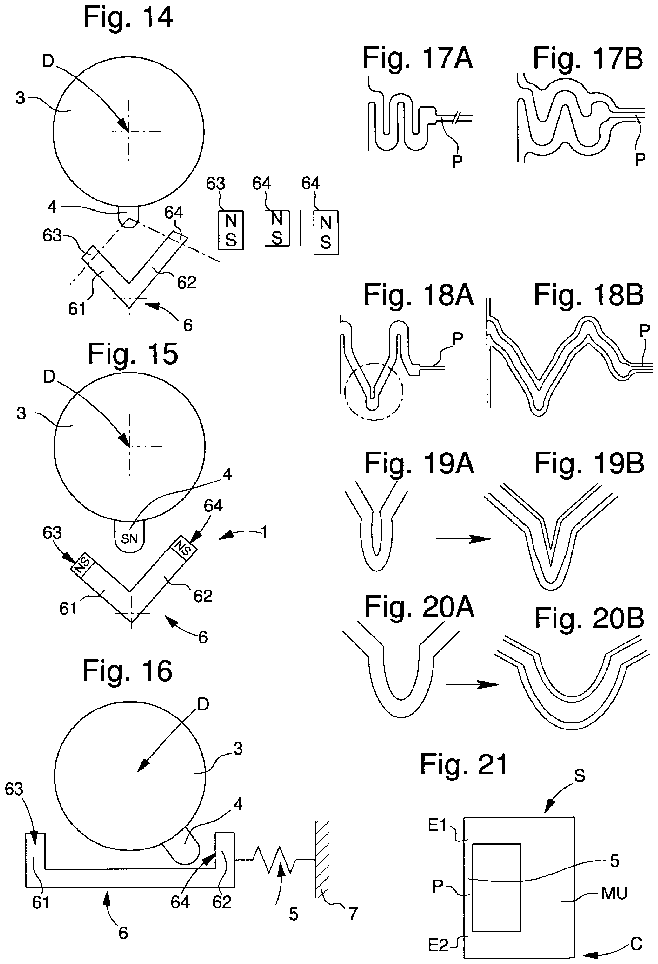

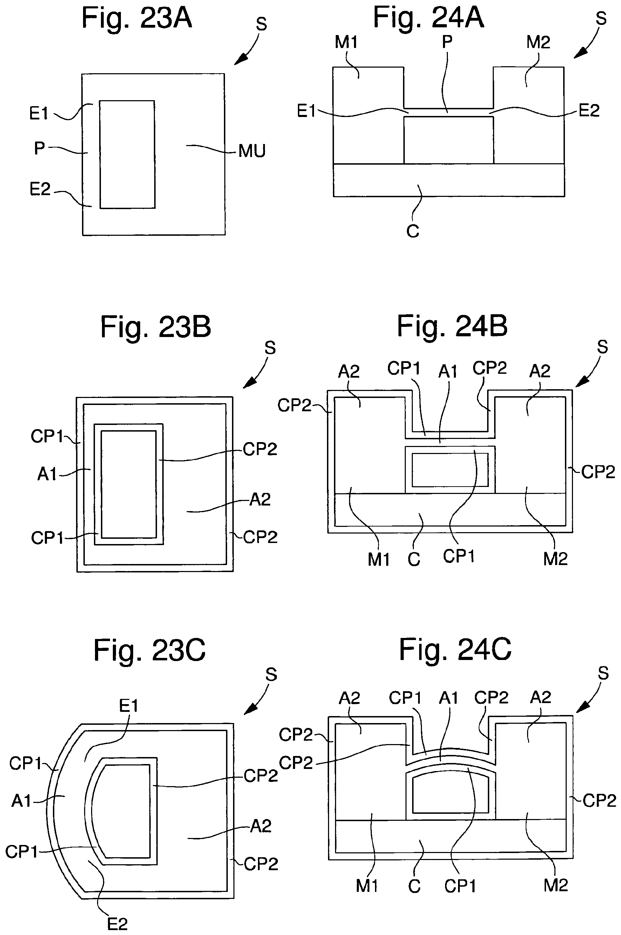

Dans une première variante, illustrée par les figures 21 et 23A, 23B, 23C, une lame flexible bistable 5 coopère avec les deux extrémités E1, E2, d'au moins une masse, et en particulier d'une masse unique MU. Le procédé comporte alors la succession des opérations suivantes :
- on grave un composant S en silicium dans lequel une poutre longiligne P de faible section fait la liaison entre deux extrémités E1, E2 d'au moins une masse MU, de forte section (au moins supérieure à dix fois cette faible section), cette au moins une masse MU constituant un cadre rigide C ;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à obtenir, au niveau de ladite poutre P, une première âme A1 en silicium enveloppée par une première couche périphérique CP1, et au niveau de ladite masse MU, une deuxième âme A2 en silicium enveloppée par une deuxième couche périphérique CP2, et de façon à ce qu'un premier rapport RA entre, d'une part la section de ladite première couche périphérique CP1 de ladite poutre P formée de dioxyde de silicium SiO₂,et d'autre part la section de ladite première âme A1 de ladite poutre P formée de silicium soit supérieur à 1,
- et de façon à ce qu'un deuxième rapport RB entre, d'une part la section de ladite deuxième couche périphérique CP2 de ladite masse MU formée de dioxyde de silicium SiO₂, et d'autre part la section de ladite deuxième âme A2 de ladite masse MU formée de silicium, soit inférieur au centième dudit premier rapport RA ;
- on effectue un refroidissement à la température ambiante, environ 20°C, de façon à déformer en flambage la poutre P lors du refroidissement de la au moins une masse MU, dont la contraction lors de ce refroidissement est supérieure à la contraction de cette poutre P.

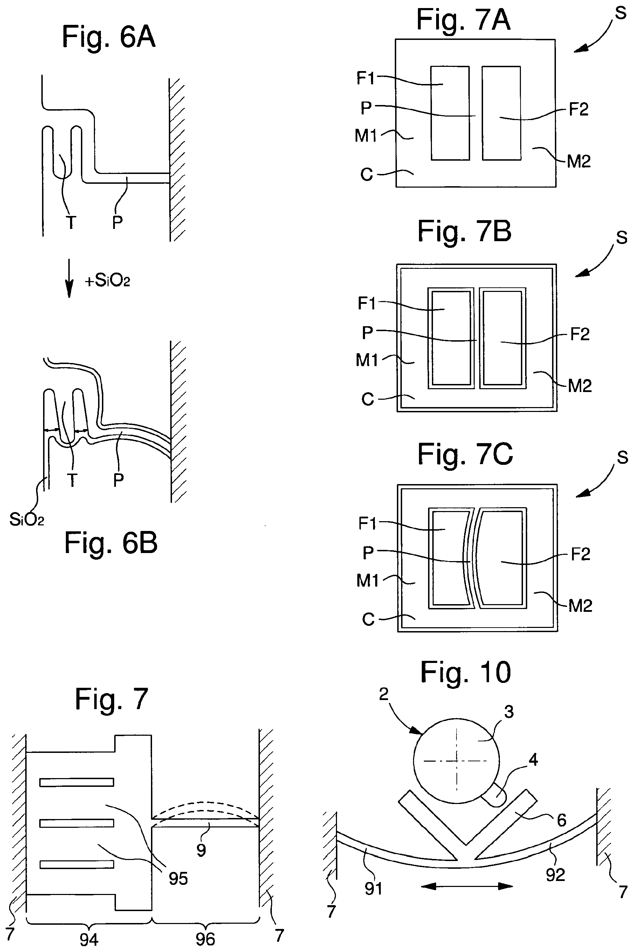

Les figures 7A, 7B, 7C, et 24A, 24B, 24C illustrent une deuxième variante de mise en oeuvre d'un procédé de réalisation d'une lame flexible bistable, impliquant au moins deux masses. Ce procédé comporte la succession des opérations suivantes :
- on grave un composant S en silicium dans lequel une poutre longiligne P de faible section fait la liaison entre au moins deux masses M1, M2, chacune de forte section au moins supérieure à dix fois cette faible section, ces deux masses M1, M2,constituant ensemble ou avec d'autres éléments de structure un cadre rigide C;
- on soumet ce composant S, dans un four, à un procédé connu de croissance de dioxyde de silicium SiO₂ par maintien pendant plusieurs heures à une température de 1100°C ;
- on ajuste cette durée de plusieurs heures de façon à obtenir, au niveau de ladite poutre P, une première âme A1 en silicium enveloppée par une première couche périphérique CP1, et au niveau de chaque dite masse M1 ; M2, une deuxième âme A2 en silicium enveloppée par une deuxième couche périphérique CP2, et de façon à ce qu'un premier rapport RA entre, d'une part la section de ladite première couche périphérique CP1 de ladite poutre P formée de dioxyde de silicium SiO₂,et d'autre part la section de ladite première âme A1 de ladite poutre P formée de silicium soit supérieur à 1,
- et à ce qu'un deuxième rapport RB entre, d'une part la section de chacune desdites deuxièmes couches périphériques CP2 desdites masses M1 ; M2 formées de dioxyde de silicium SiO₂, et d'autre part la section de chacune desdites deuxièmes âmes A2 desdites masses M1 ; M2 formées de silicium soit inférieur au centième dudit premier rapport RA,
- on effectue un refroidissement à la température ambiante, environ 20°C, de façon à déformer en flambage la poutre P lors du refroidissement des deux masses M1 et M2 dont la contraction lors de ce refroidissement est supérieure à la contraction de cette poutre P.

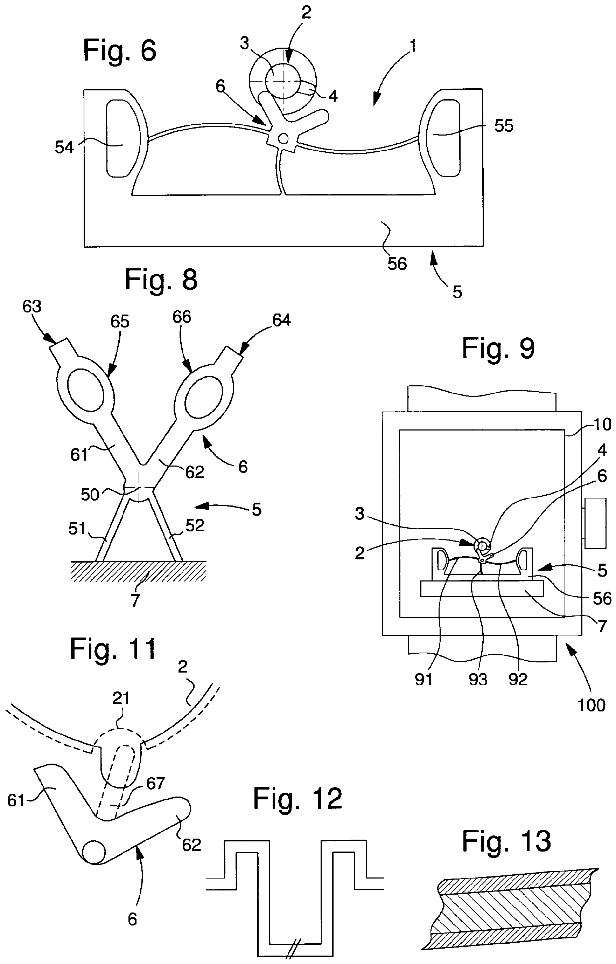

Dans un autre procédé, voisin mais différent de celui de l'invention, la structure du mécanisme anti-galop 1 est réalisée en quartz monocristallin. Tel que visible sur la figure 13, le noyau central en quartz monocristallin est revêtu sur ses faces supérieure et inférieure d'un dépôt réalisé à une température supérieure à la température ambiante, avec un coefficient α inférieur au coefficient α_{x,y} du quartz. Ce coefficient α_{x,y} du quartz est de 7,5 ppm/°C.

Dans une application avantageuse, ce procédé de fabrication d'élément flexible multistable est appliqué à un mécanisme horloger de limitation ou transmission 1000 pour limiter ou transmettre le débattement angulaire d'un mobile 2000 d'un mouvement d'horlogerie 10, ce mobile 2000 comportant au moins une cheville ou dent 4000 saillante, notamment radialement dans le cas d'une dent 5001, ou axialement dans le cas d'une cheville 4. Dans une application particulière, ce mécanisme horloger de limitation ou transmission 1000 comporte des moyens de limitation ou de transmission 6000 qui sont fixés, par l'intermédiaire au moins un tel élément flexible multistable, notamment bistable, 5, à un autre composant du mouvement 10 ou à un élément rigide de structure 7 du mouvement 10.

Dans une application particulière, ce mécanisme horloger de limitation ou transmission 1000 est un mécanisme anti-galop 1, qui est destiné à empêcher l'emballement d'un balancier d'horlogerie 2, lequel comporte un arbre 3 et une cheville 4 ou un élément similaire saillant de cet arbre 3.

Dans une application particulière, le mécanisme anti-galop 1 comporte au moins un élément monolithique bistable flexible réalisable selon l'invention, qu'on dénommera ci-après élément flexible bistable 5, porteur d'au moins une butée anti-galop 6, et qui est fixé, par l'intermédiaire d'éléments de liaison flexibles et élastiques, à un élément rigide de structure 7, tel que platine, pont, ou similaire, d'un mouvement d'horlogerie 10 dans lequel est intégré un organe régulateur auquel appartient le balancier 2.

Dans une variante particulière, cette structure 7 contient un système d'auto-alignement avec l'axe du balancier 2.

Cet élément flexible bistable 5 est porteur d'au moins une butée anti-galop 6, dont une extrémité 63 ou 64 peut, selon la position angulaire du balancier 2, venir en interférence avec la trajectoire de la cheville 4, et remplir la fonction de butée si le balancier 2 dépasse sa course angulaire normale.

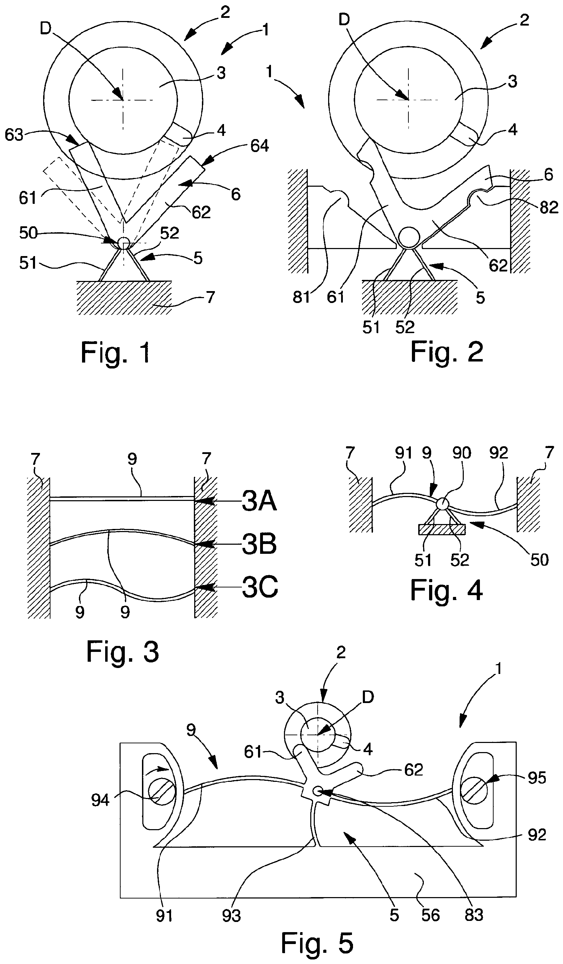

La figure 1 expose le schéma de principe, dans une application particulière, préférée mais non limitative, où l'élément flexible bistable 5 et la au moins une butée anti-galop 6 forment ensemble un composant monolithique. Dans cet exemple nullement limitatif, la butée anti-galop 6 comporte deux bras 61, 62, dont les extrémités respectives 63, 64, peuvent chacune, selon la position du balancier 2, venir en interférence avec la trajectoire de la cheville 4, et remplir la fonction de butée si le balancier 2 dépasse sa course angulaire normale. Cette réalisation à deux bras, telle qu'illustrée, assure la limitation de l'angle de rotation du balancier 2 dans les deux sens de rotation de ce dernier. La figure 1 montre, en trait interrompu, une position d'interférence avec le balancier 2, assurant la limitation de son débattement angulaire.

L'élément flexible bistable 5 est ici illustré avec ces éléments de liaison flexibles et élastiques qui sont constitués par au moins deux lames fines 51, 52, chacune fixée à une première extrémité à la structure 7, et reliées par une deuxième extrémité au corps de l'élément flexible. Dans le cas particulier de la figure 1, les deux lames fines 51, 52, sont reliées par leurs deuxièmes extrémités au corps de l'élément flexible en formant un vé, de façon à définir un pivot fictif 50 autour duquel peut pivoter la butée anti-galop 6. Ainsi, dans le cas des figures 1 et 2, l'élément flexible bistable 5 selon l'invention est un pivot flexible bistable. Ce mode de réalisation n'est pas exclusif, la figure 10 schématise le cas où la butée anti-galop 6 est mobile en translation. La figure 16 illustre un cas plus général où le mouvement est quelconque, et bistable.

De préférence, au moins deux lames flexibles 51, 91, 52, 92, sont montées précontraintes en flambage par rapport à la structure 7 ou par rapport à un bâti 56 que comporte l'élément flexible bistable 5.

Chacune des lames 51, 52 peut occuper plusieurs états, selon les efforts auxquels elle est soumise. Chacune de ces lames est calculée pour travailler en flambage, et peut adopter plusieurs géométries, selon son mode de flambage, tel que visible sur la figure 3 : au repos en 3A, en premier mode de flambage, avec une forme concave ou convexe en 3B, en deuxième mode de flambage avec une forme en S ou Z en 3C. L'élément flexible bistable 5 peut comporter des éléments flexibles avec d'autres formes que ces lames flexibles 51, 52, illustrées ici, sans s'éloigner de l'invention.

L'élément flexible bistable 5 peut, encore, dans une réalisation particulière, être réalisé monobloc avec l'élément de structure 7.

Dans une réalisation particulière, illustrée à la figure 8, des éléments flexibles 65, 66, peuvent être inclus aux bras 61, 62, de la butée 6 du mécanisme anti-galop 1, afin d'éviter des chocs trop importants.

Un tel élément flexible bistable 5 peut être réalisé par technologie silicium, « LIGA », MEMS, ou similaire. Son inertie est très faible comparée à celle du balancier 2, et son actionnement perturbe faiblement les oscillations du balancier 2.

La figure 2 illustre un mécanisme antichoc de protection des lames flexibles 51 et 52 de l'élément flexible bistable 5. Il est utile, voire nécessaire, dans les cas où les butées anti-galop 6 doivent limiter l'amplitude du balancier 2. Le but est d'absorber les chocs dans des butées antichocs 81, 82, qui coopèrent en appui de butée avec les bras 61, 62, et de ne pas transmettre ces chocs dans les lames flexibles 51, 52 afin d'éviter une rupture de celles-ci. La figure 5 présente une butée antichocs 83 coaxiale avec le pivot flexible. Dans cet exemple de réalisation les butées antichocs 81 et 82 comportent des saillantes sensiblement cylindriques, qui coopèrent avec des rainures de forme sensiblement complémentaire sur les bras 61 et 62.

Le pivot bistable flexible 5 peut être réalisé selon plusieurs principes. La figure 3 introduit un principe d'état bistable étudié dans ce cas particulier. On utilise les modes naturels de flambage d'une poutre 9 soumise à une contrainte, plus particulièrement le deuxième mode illustré en 3C.

Tel que visible sur la figure 4, dans une réalisation avantageuse, afin de contraindre la poutre 9 à flamber selon le deuxième mode, un pivot 90 oblige la poutre 9 à avoir un noeud en son milieu (centre de rotation du pivot ajouté). Le centre de rotation 50 du pivot bistable 5 correspond alors au centre de rotation du pivot 90 ajouté.

La figure 5 expose un mécanisme anti-galop 1 complet réalisé selon ce principe. Le pivot bistable flexible 5 comporte au moins une poutre 9 précontrainte en flambage selon un deuxième mode où la poutre 9 adopte une forme en S ou en Z, un pivot 90 obligeant cette poutre 9 à avoir un noeud en zone médiane, de préférence en son milieu. De façon préférée dans le cas de la figure 5, le pivot bistable flexible 5 est réalisé par flambage de deux poutres 91 et 92 précontraintes (qui composent ensemble la poutre 9) en les contraignant ici via deux vis excentrées 94 et 95. Une troisième poutre 93, fixée à la structure 7 ou à un bâti 56 de l'élément flexible bistable 5, force la poutre 9 composée des poutres 91 et 92 à se déformer dans le deuxième mode, et joue le rôle du pivot 90 de la figure 4. La butée antichoc 83 est située dans le centre de rotation 50 du pivot bistable flexible 5.

La figure 11 illustre une butée anti-galop 6 comportant au moins deux niveaux pour assurer le maintien des bras 61, 62, du système anti-galop dans le plan de la cheville 4 de balancier : un premier niveau supérieur avec des bras 61 et 62 coopérant avec cette cheville 4, et un deuxième niveau inférieur avec un dard 67 coopérant avec une encoche 21 du balancier 3.

Pour supprimer les contacts ou du moins diminuer les pressions de contact, le mécanisme anti-galop 1 avec composant réalisable selon l'invention peut encore avantageusement comporter des moyens pour créer une force ou un couple de répulsion entre le balancier 2 et les bras 61, 62, du mécanisme anti-galop 1.

La figure 14 illustre le cas où cette fonction de répulsion est remplie par des aimants situés dans une orientation verticale, au niveau de la cheville 4 et des extrémités 63, 64, des bras 61, 62. La figure 15 illustre une réalisation analogue, avec une orientation dans le plan du champ magnétique, on voit les pôles nord et sud de ces aimants.

Dans une localisation similaire, on peut avantageusement utiliser, à la place des aimants, ou en plus de ceux-ci, des électrets (charges électrostatiques) pour exercer de telles forces de répulsion.

Il s'agit d'augmenter le rendement du mécanisme anti-galop 1, et de perturber le moins possible la marche du balancier 2. Le fonctionnement du mécanisme anti-galop 1 est le suivant :
- lors du basculement, dans une première phase, le balancier 2 fournit de l'énergie à l'élément flexible bistable 5 ;
- une fois passé le point d'équilibre, dans une deuxième phase, le mécanisme restitue une partie de l'énergie au balancier 2 en faisant une petite impulsion.

Le mécanisme fonctionne de manière analogue aux cornes d'une ancre suisse, il y a un dégagement puis une impulsion.

Dans une réalisation particulière, le balancier 2, ou/et au moins les bras 61, 62, de la butée anti-galop 6, voire le mécanisme anti-galop 1 complet quand il est monobloc, dans une réalisation avantageuse, est réalisé en technologie silicium à partir d'un wafer silicium, avec ou sans croissance d'oxyde de silicium, et avec une couche superficielle renfermant, selon le cas, ou bien des aimants ou des particules magnétiques d'une part, ou bien des électrets d'autre part. Cette couche particulière peut être réalisée par un procédé galvanique, ou par pulvérisation cathodique, ou par un autre procédé microtechnique de structuration adéquat.

Dans le cas préféré d'une élaboration de l'élément flexible bistable 5 en technologie silicium, la création de contraintes dans les lames constituant les poutres 91 et 92 peut se faire par oxydation du silicium. En effet, l'oxyde de silicium prend un plus grand volume lors de sa croissance à partir du silicium, tel que visible sur la figure 6, où des poches 54, 55, de SiO2, sont créées dans un bâti 56 en silicium. On voit sur cet exemple de la figure 5 ou 6, que ce bâti 56 peut aussi constituer la structure 7, ou encore y être relié de façon très simple par toute technologie usuelle de fixation mécanique.

Les figures 6A et 6B illustrent, avant et après oxydation du silicium, un détail d'une zone comportant de fortes différences de section, et fortement modifiée après formation de dioxyde de silicium, et soumettant à un effort en flambage une poutre droite P de section moindre qu'une tête T dont elle constitue un prolongement.

Un autre moyen de réaliser les contraintes de flambage dans ces lames est l'oxydation d'une structure en silicium, de forme particulière, exposée à la figure 7. L'oxydation du silicium induit des contraintes en surface qui ont pour effet d'allonger la longueur d'une poutre oxydée. La figure 7 illustre un autre principe de précontrainte par différentiel de résistance au flambage entre un réseau de poutres parallèles en silicium oxydé et une poutre seule ainsi précontrainte en flambage, et présente un mécanisme simple où, en partie gauche, une structure parallèle 94 comporte un faisceau de poutres parallèles 95 qui vont, après oxydation (en trait interrompu), contraindre en fléchissement en flambage, en partie droite, un élément flexible à contraindre 96, en l'occurrence une poutre 9, 91, 92, ou similaire, dont on désire obtenir une déformation, la résistance au flambage de la structure parallèle 94 étant beaucoup plus grande que celle de l'élément flexible à contraindre 96. Les figures 7A, 7B, 7C, illustrent des étapes successives d'un procédé d'oxydation et de mise en flambage d'une poutre P, ménagée entre deux fenêtres F1, F2 d'un cadre C. La figure 7A montre la structure de base résultant de la mise en forme par gravure du silicium, au moment de sa mise dans un four. La figure 7B illustre le développement d'oxyde de silicium SiO₂, à l'intérieur des fenêtres F1 et F2 et donc sur les flancs de la poutre P, par maintien de la structure à 1100°C pendant plusieurs heures ; de façon connue, la croissance du dioxyde de silicium SiO₂ se fait par consommation partielle du silicium vers l'extérieur du composant, et de ce fait dans la mince poutre P la proportion de dioxyde de silicium SiO₂ augmente quand la proportion de silicium diminue, au fil du temps pendant ce traitement à 1100°C. La figure 7C montre la contraction de la structure après un refroidissement à la température ambiante, environ 20 °C: les montants latéraux M1, M2 du cadre C, parallèles à la poutre P, qui sont essentiellement formés de silicium et d'un peu de dioxyde de silicium, se contractent davantage que la poutre P, qui est alors essentiellement formée de dioxyde de silicium qui a un coefficient de dilatation plus faible que le silicium, et de ce fait la poutre P est soumise à un effort de flambage, et prend un état bistable.

Une autre variante est illustrée à la figure 12.

Les figures 17A et 17B illustrent aussi l'obtention de la précontrainte par rencontre des croissances d'oxyde dans un serpentin.

Les figures 18A et 18B (et leurs détails en figures 19A et 19B) montrent l'obtention de la précontrainte par l'ouverture des angles au sommet d'un profilé en zig-zag selon le même principe : la croissance de l'oxyde de silicium force l'ouverture de ces angles, et le déplacement est amplifié par la géométrie en Z ou en zig-zag de la structure. Les figures 20A et 20B montrent une variation d'angle obtenue par la variation du rayon de courbure des parois oxydées dans une zone à très faible rayon de courbure.

Le mécanisme anti-galop 1 illustré ici limite le sens de rotation du balancier dans les deux sens de rotation. Il ne perturbe que très faiblement les oscillations du balancier 2.

L'invention peut être utilisée pour la réalisation de composants dans les montres mécaniques ne présentant pas de mécanisme anti-galop.

Dans une autre application particulière, ce mécanisme horloger de limitation ou transmission 1000 est un mécanisme d'ancre 3000 pour mécanisme d'échappement, notamment mais non limitativement une ancre suisse, sur le même principe, pour sa coopération avec un balancier 2 et avec une roue d'échappement 5000. Une telle ancre 3000 comporte au moins un élément flexible 5 multistable, notamment bistable, réalisable par un procédé selon l'invention. Elle peut être réalisée selon une exécution d'ancre flexible à force constante selon la demande EP12183559.9 du même déposant. La coopération de cette ancre 3000 avec le balancier 2 est effectuée par des cornes 3001 analogues aux extrémités 63, 64, des bras 61 et 62 de la butée anti-galop 6 décrite ci-dessus, ces cornes 3001, portées par une première partie 3100 de l'ancre 3000, sont reliées par au moins une lame flexible 5 multistable, notamment bistable, soit à une structure fixe 7, soit de préférence à une deuxième partie 3200 de l'ancre comportant des palettes 3002 de coopération avec les dents 5001 de la roue d'échappement 5000. De la même façon, ces palettes 3002 sont avantageusement construites de façon analogue à ces bras 61 et 62, et sont reliées par au moins une lame flexible 5 multistable, notamment bistable, soit à une structure fixe 7, soit de préférence à la première partie 3100 de l'ancre comportant les cornes 3001.

De façon particulièrement avantageuse, pour améliorer la marche et le rendement, l'interaction entre les cornes 3001 et le balancier 2 d'une part, ou/et entre les palettes 3002 et la roue d'échappement 5000 d'autre part, est réalisée sans contact ou avec un contact atténué, et, à cet effet, les surfaces concernées des cornes 3001 ou/et des palettes 3002 sont magnétisées ou électrisées pour coopérer en répulsion avec des surfaces antagonistes du balancier ou/et respectivement de la roue d'échappement, qui sont en matériau adéquat, ou/et avantageusement magnétisées ou respectivement électrisées de façon complémentaire. La demande WO2012013374 au nom de SWATCH GROUP RESEARCH AND DEVELOPMENT LTD décrit une telle transmission sans contact ou à contact atténué, dont la combinaison avec un tel mécanisme flexible à lame multistable, notamment une ancre, apporte les avantages recherchés.

Une réalisation particulière avec composant réalisable par un procédé selon l'invention concerne encore un mouvement d'horlogerie 10 comportant au moins un organe régulateur à balancier 2, et qui comporte au moins un mécanisme horloger de limitation ou transmission 1000 selon avec composant réalisable par un procédé selon l'invention. Selon le cas, le mouvement 10 comporte une structure 7 à laquelle est fixé un élément flexible bistable 5 de ce mécanisme horloger de limitation ou transmission 1000, ou bien cet élément flexible bistable 5, réalisable par un procédé selon l'invention, constitue lui-même une telle structure.

Une réalisation particulière concerne encore une pièce d'horlogerie 100, notamment une montre, comportant au moins un tel mouvement 10 ou au moins un tel mécanisme horloger de limitation ou transmission 1000, avec composant réalisable par un procédé selon l'invention.

Les technologies utilisées pour la réalisation du dispositif ne se limitent pas à la technologie silicium mais également aux procédés « LIGA », MEMS, et autres procédés de micro-fabrication.

## Revendications

1. Procédé de réalisation d'un élément flexible multistable (5) par la succession des opérations suivantes :
- on réalise une ébauche (E) de composant (S) en silicium monobloc comportant, d'une part au moins une poutre souple (P) destinée à constituer une lame flexible multistable entre deux extrémités (E1, E2), et d'autre part au moins une masse rigide (M ; M1 ; M2) plus massive que toute dite poutre souple (P) et de section en tout point supérieure à celle de toute dite poutre souple (P) et toute dite masse rigide (M ; M1 ; M2) destinée à former une structure plus rigide que toute dite lame flexible multistable, et de façon à ce qu'au moins une dite poutre souple (P) de longueur curviligne initiale (LI) s'étende entre une première dite masse rigide (M1) à une première dite extrémité (E1) et une deuxième dite masse rigide (M2) à une deuxième dite extrémité (E2), lesdites première et deuxième extrémités (E1, E2) étant constituées par la limite de la zone de plus faible section de ladite poutre souple (S) avec la zone de plus forte section de ladite masse rigide (M ; M1 ; M2), et étant distantes d'une distance initiale (DI) inférieure ou égale à ladite longueur curviligne initiale (LI), et ladite première dite masse rigide (M1) et de ladite deuxième dite masse rigide (M2) formant ensemble un cadre rigide (C) qui est aussi une dite masse rigide (M);
- on soumet ledit composant (S), dans un four, à un procédé de croissance de dioxyde de silicium SiO₂ par maintien pendant plusieurs heures à une température de 1100°C ;
- on ajuste cette durée de plusieurs heures de façon à obtenir une section de dioxyde de silicium SiO₂ qui est supérieure sur toute dite masse rigide (M ; M1 ; M2) à celle sur toute dite poutre souple (P);
- on effectue un refroidissement à la température ambiante, environ 20°C, de façon à déformer en flambage au moins ladite poutre souple (P) de longueur curviligne initiale (LI) lors du refroidissement de ladite première dite masse rigide (M1) et de ladite deuxième dite masse rigide (M2) dont la contraction lors de ce refroidissement est supérieure à la contraction de ladite poutre (P), de façon à ce que la distance finale (DF) entre lesdites première et deuxième extrémités (E1, E2) soit strictement inférieure à la longueur curviligne finale (LF) de ladite poutre souple (P) de longueur curviligne initiale (LI), et à ce que ladite longueur curviligne finale (LF) soit supérieure ou égale à ladite longueur curviligne initiale (LI).

2. Procédé selon la revendication précédente, **caractérisé en ce qu'**on ajuste ladite durée de la phase de croissance de dioxyde de silicium SiO₂ pour que le ratio entre la section de dioxyde de silicium SiO₂ et la section de silicium soit plus élevé dans toute dite poutre souple (P) que dans toute dite masse rigide (M ; M1 ; M2).

3. Procédé de réalisation d'un élément flexible multistable (5) par la succession des opérations suivantes :
- on grave un composant (S) en silicium dans lequel une poutre longiligne (P) de faible section fait la liaison entre deux extrémités (E1 ; E2) d'au moins une masse (MU), de forte section au moins supérieure à dix fois ladite faible section, ladite au moins une masse (MU) constituant un cadre rigide (C) ;
- on soumet ledit composant (S), dans un four, à un procédé de croissance de dioxyde de silicium SiO₂ par maintien pendant plusieurs heures à une température de 1100°C ;
- on ajuste cette durée de plusieurs heures de façon à obtenir, au niveau de ladite poutre (P), une première âme (A1) en silicium enveloppée par une première couche périphérique (CP1), et au niveau de ladite masse (MU), une deuxième âme (A2) en silicium enveloppée par une deuxième couche périphérique (CP2), et de façon à ce qu'un premier rapport (RA) entre, d'une part la section de ladite première couche périphérique (CP1) de ladite poutre (P) formée de dioxyde de silicium SiO₂ ,et d'autre part la section de ladite première âme (A1) de ladite poutre (P) formée de silicium soit supérieur à 1,
- et de façon à ce qu'un deuxième rapport (RB) entre, d'une part la section de ladite deuxième couche périphérique (CP2) de ladite masse (MU) formée de dioxyde de silicium SiO₂, et d'autre part la section de ladite deuxième âme (A2) de ladite masse (MU) formée de silicium, soit inférieur au centième dudit premier rapport (RA) ;
- on effectue un refroidissement à la température ambiante, environ 20°C, de façon à déformer en flambage ladite poutre (P) lors du refroidissement de ladite au moins une masse (MU), dont la contraction lors de ce refroidissement est supérieure à la contraction de ladite poutre (P).

4. Procédé de réalisation d'un élément flexible multistable (5) par la succession des opérations suivantes :
- on grave un composant (S) en silicium dans lequel une poutre longiligne (P) de faible section fait la liaison entre au moins deux masses (M1; M2), chacune de forte section au moins supérieure à dix fois ladite faible section, lesdites deux masses (M1 ; M2) constituant ensemble ou avec d'autres éléments de structure un cadre rigide (C);
- on soumet ledit composant (S), dans un four, à un procédé de croissance de dioxyde de silicium SiO₂ par maintien pendant plusieurs heures à une température de 1100°C ;
- on ajuste cette durée de plusieurs heures de façon à obtenir, au niveau de ladite poutre (P), une première âme (A1) en silicium enveloppée par une première couche périphérique (CP1), et au niveau de chaque dite masse (M1 ; M2), une deuxième âme (A2) en silicium enveloppée par une deuxième couche périphérique (CP2), et de façon à ce qu'un premier rapport (RA) entre, d'une part la section de ladite première couche périphérique (CP1) de ladite poutre (P) formée de dioxyde de silicium SiO₂,et d'autre part la section de ladite première âme (A1) de ladite poutre (P) formée de silicium soit supérieur à 1,
- et à ce qu'un deuxième rapport (RB) entre, d'une part la section de chacune desdites deuxièmes couches périphériques (CP2) desdites masses (M1 ; M2) formées de dioxyde de silicium SiO₂, et d'autre part la section de chacune desdites deuxièmes âmes (A2) desdites masses (M1 ; M2) formées de silicium soit inférieur au centième dudit premier rapport (RA),
- on effectue un refroidissement à la température ambiante, environ 20°C, de façon à déformer en flambage ladite poutre (P) lors du refroidissement desdites deux masses (M1 ; M2) dont la contraction lors dudit refroidissement est supérieure à la contraction de ladite poutre (P).

5. Procédé de fabrication d'un élément flexible multistable (5) selon l'une des revendications 3 ou 4, **caractérisé en ce qu'**on réalise ledit élément flexible multistable (5) comportant d'une part une structure (56) dite indéformable avec une première raideur, et d'autre part, réalisées de façon monolithique avec ladite structure (56), des éléments de liaison (500) flexibles et élastiques d'une deuxième raideur inférieure au dixième de ladite première raideur, lesdits éléments de liaison (500) étant constitués par au moins deux lames fines (51, 91 ; 52, 92) chacune fixée à une première extrémité à ladite structure (56) et reliée par une deuxième extrémité à un corps (6) dudit élément flexible (5) en formant ensemble un vé dont le sommet, au niveau dudit corps (6), définit un pivot fictif (50) autour duquel peut pivoter ledit corps (6).

6. Procédé selon la revendication précédente, **caractérisé en ce qu'**on monte au moins deux dites lames flexibles (51, 91 ; 52, 92) précontraintes en flambage par rapport audit bâti (56).

7. Procédé selon la revendication 5 ou 6, **caractérisé en ce qu'**on forme ladite poutre (P) sous forme d'une poutre droite (9) avec deux segments (91 ; 92) montés en flambage selon un premier mode où ladite poutre (9) adopte un profil en C, ou selon un deuxième mode où ladite poutre (9) adopte une forme en S ou en Z, et sensiblement alignés de part et d'autre d'un point central agencé pour coopérer avec un pivot contraignant ladite poutre (9) à avoir un noeud audit point central et est en flambage selon ledit deuxième mode..

8. Procédé selon la revendication 5 ou 6, **caractérisé en ce qu'**on forme ladite poutre (P) sous forme d'une poutre droite (9) avec deux segments (91 ; 92), et **en ce qu'**on forme ledit élément flexible (5) avec une troisième poutre (93) fixée audit bâti (56) pour forcer ladite poutre (9) composée desdits segments (91, 92) à se déformer dans un deuxième mode où ladite poutre (9) adopte une forme en S ou en Z.

9. Procédé selon la revendication 7 ou 8, **caractérisé en ce qu'**on crée des contraintes dans les lames constituant lesdits segments (91, 92) par oxydation du silicium autour de poches (54, 55) de SiO2 qu'on crée dans ledit bâti (56) en silicium.

10. Procédé selon l'une des revendications précédentes, **caractérisé en ce qu'**on réalise ledit élément flexible (5) avec au moins une zone comportant de fortes différences de section, et dont on modifie fortement la géométrie avec une formation de dioxyde de silicium, et soumettant à un effort en flambage une poutre (P) ou une poutre droite de section moindre qu'un bord (B) ou une tête (T) dont ladite poutre (P) constitue un prolongement.

11. Procédé selon la revendication 5, **caractérisé en ce qu'**on effectue une précontrainte dudit élément flexible (5) par différentiel de résistance au flambage entre un réseau (94) de poutres parallèles en silicium oxydé et une poutre seule (96) maintenue à une première extrémité à ladite structure (56) et à une deuxième extrémité audit réseau (94), et qu'on précontraint ladite poutre seule (96) en flambage après oxydation dudit réseau (94), la résistance au flambage dudit réseau (94) étant beaucoup plus grande que celle de ladite poutre seule (96).

12. Procédé selon l'une des revendications précédentes, **caractérisé en ce qu'**on réalise une oxydation et une mise en flambage d'une poutre (P), ménagée entre deux fenêtres (F1, F2) d'un cadre (C), par le développement d'oxyde de silicium SiO₂, à l'intérieur desdites fenêtres (F1, F2) et sur les flancs de ladite poutre (P), et après contraction de la structure après un refroidissement à la température ambiante, par la contraction de montants latéraux (M1, M2) dudit cadre (C) formant chacun une dite masse rigide (M ; M1 ; M2), parallèles à ladite poutre (P), qui se contractent davantage que ladite poutre (P), qui est alors essentiellement formée de dioxyde de silicium qui a un coefficient de dilatation plus faible que le silicium, et qui est de ce fait soumise à un effort de flambage, et prend un état bistable.

13. Procédé selon l'une des revendications précédentes, **caractérisé en ce qu'**on réalise au moins une dite masse rigide (M ; M1 ; M2) sous forme d'une structure comportant des lames massives (LM) sensiblement parallèles entre elles et séparées deux à deux par une fente (F) et reliées deux à deux par un bord (B) ou une tête (T), et **en ce qu'**on ajuste ladite durée de la phase de croissance de dioxyde de silicium SiO₂ pour combler ladite fente (F) et pour écarter angulairement au moins deux dites lames massives (LM) consécutives par rapport à leur dit bord commun (B) ou à ladite tête commune (T), par rencontre et poussée des croissances d'oxyde réalisées sur lesdites lames massives (LM) consécutives.

14. Procédé selon la revendication précédente, **caractérisé en ce qu'**on réalise ledit composant avec une largeur initiale de ladite fente (F), avant croissance de dioxyde de silicium, qui est comprise entre 1 et 10 micromètres, et qu'on fait croître sur les faces en regard desdites lames massives (LM) consécutives une oxydation d'épaisseur comprise entre 1 et 10 micromètres et supérieure à la moitié de ladite largeur initiale de ladite fente (F).

15. Procédé selon l'une des revendications 13 ou 14, **caractérisé en ce qu'**on réalise une précontrainte de ladite poutre (P) par rencontre des croissances d'oxyde dans une dite structure en accordéon comportant des lames massives (LM) en forme d'accordéon ou de serpentin situé en bordure d'extrémité de ladite poutre (P).

16. Procédé selon l'une des revendications précédentes, **caractérisé en ce qu'**on réalise au moins une dite masse rigide (M ; M1 ; M2) sous forme d'une structure comportant des lames massives (LM) en zig-zag ou en Z raccordées deux à deux en un bord (B) ou une tête (T) où lesdites lames massives consécutives font entre elles un certain angle, et **en ce qu'**on ajuste ladite durée de la phase de croissance de dioxyde de silicium SiO₂ pour combler ladite fente (F) et pour écarter angulairement au moins deux dites lames massives (LM) consécutives par rapport à leur dit bord commun (B) ou à leur tête commune (T), par rencontre et poussée des croissances d'oxyde réalisées sur lesdites lames massives (LM) consécutives, et **en ce qu'**on réalise une précontrainte de ladite poutre (P), par l'ouverture desdits angles au sommet de ladite structure en zig-zag située en bordure d'extrémité de ladite poutre (P), par la croissance du dioxyde de silicium forçant l'ouverture desdits angles, le déplacement étant amplifié par la géométrie en Z ou en zig-zag de ladite structure.

17. Procédé selon l'une des revendications précédentes, **caractérisé en ce qu'**on ajuste ladite durée de la phase de croissance de dioxyde de silicium SiO₂ pour que la section de toute dite poutre (P) comporte entre 10% et 100% de dioxyde de silicium en final.

18. Procédé selon l'une des revendications précédentes, **caractérisé en ce qu'**on ajuste ladite durée de la phase de croissance de dioxyde de silicium SiO₂ pour que la section de toute dite masse rigide (M ; M1 ; M2) comporte entre 0,1% et 50% de dioxyde de silicium en final.

## Patentansprüche

1. Verfahren zum Herstellen eines multistabilen flexiblen Elements (5) durch die Abfolge der folgenden Schritte:
- Herstellen eines Rohlings (E) einer Monoblock-Komponente (S) aus Silicium, der einerseits mindestens einen biegsamen Balken (P), der dazu bestimmt ist, ein multistabiles flexibles Plättchen zwischen zwei Enden (E1, E2) zu bilden, und andererseits mindestens eine starre Masse (M; M1; M2), die massiver als der gesamte biegsame Balken (P) ist und einen Querschnitt besitzt, der an jedem Punkt größer als jener des gesamten biegsamen Balkens (P) ist, umfasst, und die gesamte starre Masse (M; M1; M2) dazu bestimmt ist, eine starrere Struktur als das gesamte multistabile flexible Plättchen zu bilden, und derart, dass sich mindestens ein biegsamer Balken (P) mit gekrümmter Anfangslänge (LI) zwischen einer ersten starren Masse (M1) mit einem ersten Ende (E1) und einer zweiten starren Masse (M2) mit einem zweiten Ende (E2) erstreckt, wobei das erste und das zweite Ende (E1, E2) durch den Rand des Bereichs mit kleinerem Querschnitt des biegsamen Balkens (S) mit dem Bereich mit größerem Querschnitt der starren Masse (M; M1; M2) gebildet sind und um einen Anfangsabstand (DI) beabstandet sind, der kleiner oder gleich der gekrümmten Anfangslänge (LI) ist, wobei die erste starre Masse (M1) und die zweite starre Masse (M2) zusammen einen starren Rahmen (C) bilden, der ebenfalls eine starre Masse (M) ist;
- Beaufschlagen der Komponente (S) in einem Ofen mit einem Verfahren zum Aufwachsenlassen von Siliciumdioxid SiO₂ durch Halten während mehrerer Stunden auf einer Temperatur von 1100 °C;
- Einstellen dieser Dauer von mehreren Stunden in einer Weise, dass ein Querschnitt aus Siliciumdioxid SiO₂ erhalten wird, der über die gesamte starre Masse (M; M1; M2) größer als jener des gesamten biegsamen Balkens (P) ist;
- Vornehmen einer Abkühlung auf Umgebungstemperatur von ungefähr 20 °C, um zumindest den biegsamen Balken (P) mit gekrümmter Anfangslänge (LI) während der Abkühlung der ersten starren Masse (M1) und der zweiten starren Masse (M2), deren Kontraktion während der Abkühlung größer als die Kontraktion des Balkens (P) ist, durch Knicken zu verformen, derart, dass der Endabstand (DF) zwischen dem ersten und dem zweiten Ende (E1, E2) streng kleiner als die gekrümmte Endlänge (LF) des nachgiebigen Balkens (P) mit gekrümmter Anfangslänge (LI) ist, und derart, dass die endgültige gekrümmte Länge (LF) größer oder gleich der anfänglichen gekrümmten Länge (LI) ist.

2. Verfahren nach dem vorhergehenden Anspruch, **dadurch gekennzeichnet, dass** die Dauer der Wachstumsphase von Siliciumdioxid SiO₂ so eingestellt wird, dass das Verhältnis zwischen dem Querschnitt aus Siliciumdioxid SiO₂ und dem Querschnitt aus Silicium in dem gesamten biegsamen Balken (P) höher als in der gesamten starren Masse (M; M1; M2) ist.

3. Verfahren zum Herstellen eines multistabilen flexiblen Elements (5) durch die Abfolge der folgenden Schritte:
- Ätzen einer Komponente (S) aus Silicium, in der ein langgestreckter Balken (P) mit kleinem Querschnitt die Verbindung zwischen zwei Enden (E1; E2) mindestens einer Masse (MU) mit großem Querschnitt, der zumindest größer als der zehnfache kleine Querschnitt ist, bildet, wobei die mindestens eine Masse (MU) einen starren Rahmen (C) bildet;
- Beaufschlagen der Komponente (S) in einem Ofen mit einem Verfahren zum Aufwachsenlassen von Siliciumdioxid SiO₂ durch Halten während mehrerer Stunden auf einer Temperatur von 1100 °C;
- Einstellen dieser Dauer von mehreren Stunden in einer Weise, dass auf Höhe des Balkens (P) ein erster Kern (A1) aus Silicium, der von einer ersten Umfangsschicht (CP1) umhüllt ist, und auf Höhe der Masse (MU) ein zweiter Kern (A2) aus Silicium, der von einer zweiten Umfangsschicht (CP2) umhüllt ist, erhalten werden, und derart, dass ein erstes Verhältnis (RA) zwischen einerseits dem Querschnitt der ersten Umfangsschicht (CP1) des Balkens (P), der aus Siliciumdioxid SiO₂ gebildet ist, und andererseits dem Querschnitt des ersten Kerns (A1) des Balkens (P), der aus Silicium gebildet ist, größer als 1 ist,
- und derart, dass ein zweites Verhältnis (RB) zwischen einerseits dem Querschnitt der zweiten Umfangsschicht (CP2) der Masse (MU), der aus Siliciumdioxid SiO₂ gebildet ist, und andererseits dem Querschnitt des zweiten Kerns (A2) der Masse (MU), der aus Silicium gebildet ist, kleiner als ein Hundertstel des ersten Verhältnisses (RA) ist;
- Vornehmen einer Abkühlung auf Umgebungstemperatur von ungefähr 20 °C, um den Balken (P) bei der Abkühlung der wenigstens einen Masse (MU), deren Kontraktion bei dieser Abkühlung größer als die Kontraktion des Balkens (P) ist, durch Knicken zu verformen.

4. Verfahren zum Herstellen eines multistabilen flexiblen Elements (5) durch die Abfolge der folgenden Schritte:
- Ätzen einer Komponente (S) aus Silicium, in der ein langgestreckter Balken (P) mit kleinem Querschnitt die Verbindung zwischen wenigstens zwei Massen (M1; M2) bildet, wovon jede einen großen Querschnitt besitzt, der zumindest größer als der zehnfache kleine Querschnitt ist, wobei die zwei Massen (M1; M2) gemeinsam oder mit anderen Strukturelementen einen starren Rahmen (C) bilden;
- Beaufschlagen der Komponente (S) in einem Ofen mit einem Verfahren zum Aufwachsenlassen von Siliciumdioxid SiO₂ durch Halten während mehrerer Stunden auf einer Temperatur von 1100 °C;
- Einstellen dieser Dauer von mehreren Stunden in einer Weise, dass auf Höhe des Balkens (P) ein erster Kern (A1) aus Silicium, der von einer ersten Umfangsschicht (CP1) umhüllt ist, und auf Höhe jeder Masse (M1; M2) ein zweiter Kern (A2) aus Silicium, der von einer zweiten Umfangsschicht (CP2) umhüllt ist, erhalten werden, und derart, dass ein erstes Verhältnis (RA) zwischen einerseits dem Querschnitt der ersten Umfangsschicht (CP1) des Balkens (P), der aus Siliciumdioxid SiO₂ gebildet ist, und andererseits dem Querschnitt des ersten Kerns (A1) des Balkens (P), der aus Silicium gebildet ist, größer als 1 ist,
- und dass ein zweites Verhältnis (RB) zwischen einerseits dem Querschnitt jeder der zweiten Umfangsschichten (CP2) der Massen (M1; M2), der aus Siliciumdioxid SiO₂ gebildet sind, und andererseits dem Querschnitt jedes der zweiten Kerne (A2) der Massen (M1; M2), die aus Silicium gebildet sind, kleiner als ein Hundertstel des ersten Verhältnisses (RA) ist,
- Vornehmen einer Abkühlung auf Umgebungstemperatur von ungefähr 20 °C, um den Balken (P) bei der Abkühlung dieser zwei Massen (M1; M2), deren Kontraktion bei der Abkühlung größer als die Kontraktion des Balkens (P) ist, durch Knicken zu verformen.

5. Verfahren zum Herstellen eines multistabilen flexiblen Elements (5) nach einem der Ansprüche 3 oder 4, **dadurch gekennzeichnet, dass** das multistabile flexible Element (5) hergestellt wird, umfassend einerseits eine als nicht verformbare bezeichnete Struktur (56) mit einer ersten Steifigkeit und andererseits monolithisch mit der Struktur (56) hergestellte flexible und elastische Verbindungselemente (500) mit einer zweiten Steifigkeit, die kleiner als ein Zehntel der ersten Steifigkeit ist, umfasst, wobei die Verbindungselemente (500) durch wenigstens zwei dünne Plättchen (51, 91; 52, 92) gebildet sind, wovon jedes mit einem ersten Ende an der Struktur (56) befestigt ist und durch ein zweites Ende mit einem Körper (6) des flexiblen Elements (5) verbunden ist, und gemeinsam ein V bilden, dessen Scheitel auf Höhe des Körpers (6) einen fiktiven Drehpunkt (50) definiert, um den der Körper (6) schwenken kann.

6. Verfahren nach dem vorhergehenden Anspruch, **dadurch gekennzeichnet, dass** mindestens zwei flexible Plättchen (51, 91; 52, 92), die durch Knicken in Bezug auf den Rahmen (56) vorgespannt sind, montiert werden.

7. Verfahren nach Anspruch 5 oder 6, **dadurch gekennzeichnet, dass** der Balken (P) in Form eines geradlinigen Balkens (9) mit zwei Abschnitten (91; 92) gebildet wird, die durch Knicken gemäß einer ersten Weise, in der der Balken (9) ein C-Profil annimmt, oder gemäß einer zweiten Weise, in der der Balken (9) eine S- oder Z-Form annimmt, montiert sind und auf beiden Seiten eines mittleren Punkts im Wesentlichen ausgerichtet sind, der angeordnet ist, um mit einem Drehzapfen zusammenzuwirken, wodurch der Balken (9) an dem mittleren Punkt einen Knoten aufweisen muss und gemäß der zweiten Weise geknickt ist.

8. Verfahren nach Anspruch 5 oder 6, **dadurch gekennzeichnet, dass** der Balken (P) in Form eines geradlinigen Balkens (9) mit zwei Abschnitten (91; 92) gebildet wird und dass das flexible Element (5) mit einem dritten Balken (93) gebildet wird, der an dem Rahmen (56) befestigt ist, um den aus den Abschnitten (91, 92) gebildeten Balken (9) zu zwingen, sich gemäß einer zweiten Weise zu verformen, in dem der Balken (9) eine S- oder Z-Form annimmt.

9. Verfahren nach Anspruch 7 oder 8, **dadurch gekennzeichnet, dass** in den Plättchen, die die Abschnitte (91, 92) bilden, Spannungen durch Oxidation von Silicium um Taschen (54, 55) aus SiO₂, die in dem Rahmen (56) aus Silicium gebildet werden, erzeugt werden.

10. Verfahren nach einem der vorhergehenden Ansprüche, **dadurch gekennzeichnet, dass** das flexible Element (5) mit wenigstens einem Bereich hergestellt wird, der große Unterschiede im Querschnitt aufweist, und dessen Geometrie durch eine Bildung von Siliciumdioxid stark verändert wird, und wobei ein Balken (P) oder ein geradliniger Balken mit einem Querschnitt, der kleiner ist als ein Rand (B) oder ein Kopf (T), wovon der Balken (P) eine Verlängerung bildet, einer Knickbeanspruchung unterworfen wird.

11. Verfahren nach Anspruch 5, **dadurch gekennzeichnet, dass** eine Vorspannung des flexiblen Elements (5) durch einen Unterschied des Knickwiderstands zwischen einem Gitter (94) paralleler Balken aus oxidiertem Silicium und einem einzelnen Balken (96), der an einem ersten Ende der Struktur (56) und an einem zweiten Ende des Gitters (94) gehalten wird, ausgeübt wird und dass der einzelne Balken (96) nach der Oxidation des Gitters (94) durch Knicken vorgespannt wird, wobei der Knickwiderstand des Gitters (94) viel größer als jener des einzelnen Balkens (96) ist.

12. Verfahren nach einem der vorhergehenden Ansprüche, **dadurch gekennzeichnet, dass** eine Oxidation und ein Knicken eines Balkens (P), der zwischen zwei Fenstern (F1, F2) eines Rahmens (C) angeordnet ist, ausgeführt werden durch Entwickeln von Siliciumdioxid SiO₂ innerhalb der Fenster (F1, F2) und auf den Seitenflächen des Balkens (P) und nach einer Kontraktion der Struktur nach einer Abkühlung auf Umgebungstemperatur durch die Kontraktion seitlicher Streben (M1, M2) des Rahmens (C), die jeweils eine starre Masse (M; M1; M2), die zu dem Balken (P) parallel sind, bilden und sich mehr als der Balken (P) kontrahieren, der dann im Wesentlichen aus Siliciumdioxid gebildet ist, das einen Ausdehnungskoeffizienten besitzt, der kleiner als jener von Silicium ist, und der dadurch einer Knickbeanspruchung unterliegt und einen bistabilen Zustand einnimmt.

13. Verfahren nach einem der vorhergehenden Ansprüche, **dadurch gekennzeichnet, dass** mindestens eine starre Masse (M; M1; M2) in Form einer Struktur hergestellt wird, die massive Plättchen (LM) aufweist, die im Wesentlichen zueinander parallel sind und paarweise durch einen Schlitz (F) getrennt und paarweise durch einen Rand (B) oder einen Kopf (T) verbunden sind, und dass die Dauer der Wachstumsphase von Siliciumdioxid SiO₂ eingestellt wird, um den Schlitz (F) zu füllen und um mindestens zwei aufeinander folgende massive Plättchen (LM) in Bezug auf ihren gemeinsamen Rand (B) oder den gemeinsamen Kopf (T) in Winkelrichtung zu beabstanden durch Aufeinandertreffen und Druck der gewachsenen Oxide, die auf den aufeinander folgenden massiven Plättchen (LM) ausgebildet werden.

14. Verfahren nach dem vorhergehenden Anspruch, **dadurch gekennzeichnet, dass** die Komponente mit einer Anfangsbreite des Schlitzes (F) vor dem Wachstum von Siliciumdioxid ausgebildet wird, die im Bereich von 1 bis 10 Mikrometern liegt, und dass auf den Flächen gegenüber den aufeinander folgenden massiven Plättchen (LM) ein Wachstum einer Oxidation mit einer Dicke von 1 bis 10 Mikrometern und größer als die Hälfte der Anfangsbreite des Schlitzes (F) bewirkt wird.

15. Verfahren nach einem der Ansprüche 13 oder 14, **dadurch gekennzeichnet, dass** eine Vorspannung des Balkens (P) durch Aufeinandertreffen der gewachsenen Oxide in einer Akkordeonstruktur, die massive Plättchen (LM) in Akkordeonform oder Serpentinenform umfasst, die sich am Rand eines Endes des Balkens (P) befindet, ausgeübt wird.

16. Verfahren nach einem der vorhergehenden Ansprüche, **dadurch gekennzeichnet, dass** mindestens eine starre Masse (M; M1; M2) in Form einer Struktur ausgebildet wird, die massive Plättchen (LM) in Zickzack- oder Z-Form umfasst, die paarweise an einem Rand (B) oder einem Kopf (T) verbunden sind, wo die aufeinander folgenden massiven Plättchen in einem bestimmten Winkel zueinander stehen, und dass die Dauer der Wachstumsphase von Siliciumdioxid SiO₂ so eingestellt wird, dass der Schlitz (F) gefüllt wird und dass mindestens zwei aufeinander folgende massive Plättchen (LM) in Bezug auf ihren gemeinsamen Rand (B) oder ihren gemeinsamen Kopf (T) in Winkelrichtung beabstandet werden durch Aufeinandertreffen und Druck der gewachsenen Oxide, die sich auf den aufeinander folgenden massiven Plättchen (LM) ausbilden, und dass eine Vorspannung des Balkens (P) durch Öffnen der Winkel am Scheitel der Zickzack-Struktur, die sich am Rand eines Endes des Balkens (P) befindet, durch das Wachstum von Siliciumdioxid, das die Öffnung der Winkel erzwingt, ausgeübt wird, wobei die Verlagerung durch die Z- oder Zickzack-Geometrie der Struktur verstärkt wird.

17. Verfahren nach einem der vorhergehenden Ansprüche, **dadurch gekennzeichnet, dass** die Dauer der Wachstumsphase von Siliciumdioxid SiO₂ so eingestellt wird, dass der Querschnitt des gesamten Balkens (P) am Ende 10 % bis 100 % Siliciumdioxid enthält.

18. Verfahren nach einem der vorhergehenden Ansprüche, **dadurch gekennzeichnet, dass** die Dauer der Wachstumsphase von Siliciumdioxid SiO₂ in der Weise eingestellt wird, dass der Querschnitt der gesamten starren Masse (M; M1; M2) am Ende 0,1 % bis 50 % Siliciumdioxid enthält.

## Claims

1. Method for creating a flexible, multistable element (5) by the following series of operations:
- there is made a blank (E) of a single-piece silicon component (S) including, on the one hand, at least one flexible beam (P) intended to form a flexible, multistable blade between two ends (E1, E2), and on the other hand, at least one rigid mass (M; M1; M2) of greater mass than any said flexible beam (P) and having a larger cross-section at every point than that of any said flexible beam (P) and any said rigid mass (M; M1; M2) intended to form a more rigid structure than any said flexible, multistable blade, and so that at least one said flexible beam (P) having an initial curvilinear length (LI) extends between a first said rigid mass (M1) at a first said end (E1) and a second said rigid mass (M2) at a second said end (E2), said first and second ends (E1, E2) being formed by the boundary of the area of smallest cross-section of said flexible beam (S) with the area of largest cross-section of said rigid mass (M; M1; M2), and being separated by an initial distance (DI) less than or equal to said initial curvilinear length (LI), and said first rigid mass (M1) and said second rigid mass (M2) forming together a rigid frame (C) which is also a said rigid mass (M);
- said component (S) is subjected, in a furnace, to a silicon dioxide SiO₂ growth method by maintaining a temperature of 1100°C for several hours;
- said duration of several hours is adjusted to obtain a cross-section of silicon dioxide SiO₂ which is greater on any said rigid mass (M; M1; M2) than that on any said flexible beam (P);
- cooling is performed to ambient temperature, around 20°C, so as to deform by buckling at least said flexible beam (P) having an initial curvilinear length (LI) during the cooling of said first rigid mass (M1) and of said second rigid mass (M2) whose contraction during cooling is greater than the contraction of said beam (P), so that the final distance (DF) between said first and second ends (E1, E2) is strictly less than the final curvilinear length (LF) of said flexible beam (P) having an initial curvilinear length (LI), and so that said final curvilinear length (LF) is greater than or equal to said initial curvilinear length (LI).

2. Method according to the preceding claim, **characterized in that** said duration of the silicon dioxide SiO₂ growth phase is adjusted so that the ratio between the cross-section of silicon dioxide SiO₂ and the cross-section of silicon is higher in any said flexible beam (P) than in any said rigid mass (M; M1; M2).

3. Method for creating a flexible, multistable element (5) by the following series of operations:
- a silicon component (S) is etched in which a slender beam (P) of small cross-section forms the connection between two ends (E1; E2) of at least one mass (MU) of large cross-section, at least ten times greater than said small cross-section, said at least one mass (MU) forming a rigid frame (C);
- said component (S) is subjected, in a furnace, to a silicon dioxide SiO₂ growth method by maintaining a temperature of 1100°C for several hours;
- this duration of several hours is adjusted to obtain, on said beam (P), a first silicon core (A1) covered with a first peripheral layer (CP1), and on said mass (MU), a second silicon core (A2) covered with a second peripheral layer (CP2), and so that a first ratio (RA) between, on the one hand, the cross-section of said first peripheral layer (CP1) of said beam (P) formed of silicon dioxide SiO₂, and on the other hand, the cross-section of said first core (A1) of said beam (P) formed of silicon is higher than 1,
- and so that a second ratio (RB) between, on the one hand, the cross-section of said second peripheral layer (CP2) of said mass (MU) formed of silicon dioxide SiO₂, and on the other hand, the cross-section of said second core (A2) of said mass (MU) formed of silicon, is less than a hundredth of said first ratio (RA),
- cooling is performed to ambient temperature, around 20°C, to deform said beam (P) by buckling during the cooling of said at least one mass (MU), whose contraction during cooling is greater than the contraction of said beam (P).

4. Method for creating a flexible, multistable element (5) by the following series of operations:
- a silicon component (S) is etched in which a slender beam (P) of small cross-section forms the connection between at least two masses (M1; M2) each of large cross-section, at least ten times greater than said small cross-section, said two masses (M1, M2) forming together, or with other structural elements, a rigid frame (C);
- said component (S) is subjected, in a furnace, to a silicon dioxide SiO₂ growth method by maintaining a temperature of 1100°C for several hours;
- this duration of several hours is adjusted to obtain, on said beam (P), a first silicon core (A1) covered with a first peripheral layer (CP1), and on each said mass (M1; M2), a second silicon core (A2) covered with a second peripheral layer (CP2), and so that a first ratio (RA) between, on the one hand, the cross-section of said first peripheral layer (CP1) of said beam (P) formed of silicon dioxide SiO₂, and on the other hand, the cross-section of said first core (A1) of said beam (P) formed of silicon is higher than 1,
- and so that a second ratio (RB) between, on the one hand, the cross-section of each of said second peripheral layers (CP2) of said masses (M1; M2) formed of silicon dioxide SiO₂, and on the other hand, the cross-section of each of said second cores (A2) of said second masses (M1; M2) formed of silicon, is less than a hundredth of said first ratio (RA),
- cooling is performed to ambient temperature, around 20°C, so as to deform said beam (P) by buckling during the cooling of said two masses (M1; M2), whose contraction during said cooling is greater than the contraction of said beam (P).

5. Method for manufacturing a flexible, multistable element (5) according to any of claims 3 or 4, **characterized in that** said flexible, multistable element (5) is created including, on the one hand, a structure (56) known as a deformation resistant structure and having a first stiffness, and on the other hand, made in a single-piece with said structure (56), flexible, elastic connecting elements (500) having a second stiffness less than one tenth of said first stiffness, said connecting elements (500) being formed by at least two thin blades (51, 91; 52, 92) each fixed at a first end to said structure (56) and connected by a second end to a body (6) of said flexible element (5) and forming together a V shape whose apex, on said body (6), defines a virtual pivot (50) about which said body (6) can pivot.

6. Method according to the preceding claim, **characterized in that** at least two said flexible blades (51, 91; 52, 92) are mounted prestressed and buckled in relation to said frame (56).

7. Method according to claim 5 or 6, **characterized in that** said beam (P) is formed in the shape of a straight beam (9) with two segments (91; 92) mounted buckled in a first mode wherein said beam (9) adopts a C-shaped profile, or in a second mode wherein said beam (9) adopts an S or Z shape, and substantially aligned on either side of a central point arranged to cooperate with a pivot forcing said beam (9) to have a node at the central point and to be buckled in said second mode.

8. Method according to claim 5 or 6, **characterized in that** said beam (P) is formed in the shape of a straight beam (9) with two segments (91; 92), and **in that** said flexible element (5) is formed with a third beam (93) fixed to said frame (56) to force said beam (9) composed of said segments (91; 92) to deform in a second mode wherein said beam (9) adopts an S or Z shape.

9. Method according to claim 7 or 8, **characterized in that** stresses are created in the blades forming said segments (91, 92) by silicon oxidation around pouches (54, 55) of SiO₂ which are created in said silicon frame (56).

10. Method according to any of the preceding claims, **characterized in that** said flexible element (5) is made with at least one area having large differences in cross-section, and whose geometry is greatly modified with the formation of silicon dioxide, and subjecting to buckling stress a beam (P) or a straight beam of smaller cross-section than an edge (B) or a head (T) of which said beam (P) forms an extension.

11. Method according to claim 5, **characterized in that** said flexible element (5) is prestressed using the buckling resistance differential between a network (94) of parallel silicon oxide beams and a single beam (96) connected at a first end to said structure (56) and at a second end to said network (94), and said single beam (96) is subjected to buckling prestress after oxidation of said network (96), the buckling resistance of said network (94) being much greater than that of said single beam (96).

12. Method according to any of the preceding claims, **characterized in that** a beam (P), arranged between two apertures (F1, F2) of a frame (C), is subjected to oxidation and buckling, by the growth of silicon dioxide SiO₂ inside said apertures (F1, F2) and on the sides of said beam (P), and after contraction of the structure following cooling to ambient temperature, by the contraction of side posts (M1, M2) of said frame (C) each forming a said rigid mass (M; M1; M2), parallel to said beam (P), which contract more than said beam (P), which is then essentially formed of silicon dioxide which has a lower expansion coefficient than silicon, and which is consequently subjected to buckling stress, and takes a bistable state.

13. Method according to any of the preceding claims, **characterized in that** at least one said rigid mass (M; M1; M2) is made in the form of a structure including solid blades (LM) substantially parallel to each other and separated in pairs by a slot (F) and connected in pairs by an edge (B) or a head (T), and **in that** said duration of the silicon dioxide SiO₂ growth phase is adjusted to fill said slot (F) and to angularly separate at least two consecutive said solid blades (LM) with respect to the common edge (B) thereof or to said common head (T), through encounter with and development of oxide growths on said consecutive solid blades (LM).

14. Method according to the preceding claim, **characterized in that** said component is made with an initial width of said slot (F), prior to silicon dioxide growth, which is comprised between 1 and 10 micrometres, and **in that** there is grown on the opposite surfaces of said consecutive solid blades (LM) an oxidation having a thickness comprised between 1 and 10 micrometres and greater than half said initial width of said slot (F).

15. Method according to any of claims 13 or 14, **characterized in that** said beam (P) is prestressed through encounter with oxide growths in a said accordion structure including solid blades (LM) in an accordion or coiled shape located at the extreme edge of said beam (P).

16. Method according to any of the preceding claims, **characterized in that** at least one said rigid mass (M; M1; M2) is made in the form of a structure including zigzag or Z-shaped solid blades (LM) connected in pairs at an edge (B) or a head (T) wherein a certain angle is formed between said consecutive solid blades, and **in that** said duration of the silicon dioxide SiO₂ growth phase is adjusted to fill said slot (F) and to angularly separate at least two said consecutive solid blades (LM) with respect to the common edge (B) thereof or to the common head (T) thereof, through encounter with and development of oxide growths formed on said consecutive solid blades (LM), and **in that** said beam (P) is prestressed, by opening said apex angles of said zigzag structure located at the extreme edge of said beam (P), by the silicon dioxide growth forcing the opening of said angles, the displacement being amplified by the Z-shaped or zigzag geometry of said structure.

17. Method according to any of the preceding claims, **characterized in that** said duration of the silicon dioxide SiO₂ growth phase is adjusted so that the cross-section of any said beam (P) ultimately includes between 10% and 100% silicon dioxide.

18. Method according to any of the preceding claims, **characterized in that** said duration of the silicon dioxide SiO₂ growth phase is adjusted so that the cross-section of any said rigid mass (M; M 1; M2) ultimately includes between 0.1 % and 50% silicon dioxide.
